# EUROPÄISCHE PATENTANMELDUNG

(11) **EP 0 673 067 A2**
(43) Veröffentlichungstag der Anmeldung: **20.09.1995**
(21) Anmeldenummer: 95103226.7
(22) Anmeldetag: 07.03.1995
(51) Int. Cl.: H01L 23/538, H01L 23/66

(54) **Hochfrequenzschaltung mit integrierter Logikschaltung**

(30) Priorität: 17.03.1994 DE 4409100
(71) Anmelder: Daimler-Benz Aerospace Aktiengesellschaft, D-81663 München (DE)
(72) Erfinder: Feldle, Heinz-Peter, Dr.-Ing.,, D-89250 Senden (DE); Feurer, Ernst, Dr.rer.nat.,, D-89134 Blaustein (DE); Holl, Bruno, Dr.rer.nat.,, D-89075 Ulm (DE); Oppermann, Martin, Dr.rer.nat.,, D-89081 Ulm (DE); Ott, Hubert, Dipl.-Ing.,, D-89081 Ulm (DE); Schweizer, Bernhard, Dipl.-Ing.,, D-89077 Ulm (DE)
(74) Vertreter: Fröhling, Werner Otto, Dr.

(57) **Zusammenfassung**

Die Erfindung betrifft eine Hochfrequenzschaltung mit integrierter Logikschaltung, wobei die Hochfrequenzschaltung als planare Schaltung auf der Oberseite eines Substrats angeordnet ist mit einer Grundmetallisierung der Unterseite des Substrats.

Um die Signalwege und damit die Signallaufzeiten zwischen der Hochfrequenzschaltung und der Logikschaltung möglichst kurz halten zu können, wird nach der Erfindung vorgeschlagen, daß die integrierte Logikschaltung als Dünnfilm-Mehrlagenschaltung auf der Unterseite des Substrats unter Einbeziehung der Grundmetallisierung oder auf der Oberseite des Substrats ausgebildet ist.

## Beschreibung

Die Erfindung betrifft eine Hochfrequenzschaltung mit integrierter Logikschaltung gemäß Oberbegriff des Patentanspruchs 1.

Aus der P 41 15 316 ist eine Dünnfilm-Mehrlagenschaltung bekannt, die als Logikschaltung eingesetzt werden kann und die aus mehreren Leiterbahnschichten mit dazwischenliegenden Isolationsschichten (Dielektrika) aus organischen Polymeren besteht und die auf ein Substrat aufgebracht ist. Die einzelnen Leiterbahnschichten weisen dabei jeweils eine Grundmetallisierung auf; die Grundmetallisierung der untersten Leiterbahnschicht ist dabei auf dem Substrat aufgebracht. Das Substrat besteht bei dieser Dünnfilm-Mehrlagenschaltung aus Aluminiumnitrid oder Siliziumnitrid oder Metall (z.B. Kupfer-Molybdän (CuMo)). Erwähnt werden auch Substrate aus Aluminiumoxid (Al₂O₃).

Ferner ist allgemein bekannt, daß Hochfrequenzschaltungen als planare Schaltungen (z.B. in Streifenleitungstechnik) auf einem Substrat aufgebracht werden können, wobei die Hochfrequenz-Streifenleitungsstruktur auf der Oberseite des Substrats zusammen mit einer Grundmetallisierung auf der Unterseite des Substrats die Hochfrequenzschaltung bildet.

Die Aufgabe der Erfindung besteht darin, eine Hochfrequenzschaltung anzugeben, bei der die Signalwege und damit die Signallaufzeiten zwischen der eigentlichen Hochfrequenzschaltung und der Logikschaltung möglichst kurz sind.

Die erfindungsgemäße Lösung dieser Aufgabe wird durch die kennzeichnenden Merkmale des Patentanspruchs 1 wiedergegeben. Die weiteren Ansprüche enthalten vorteilhafte Aus- und Weiterbildungen der Erfindung (Ansprüche 2 bis 7) sowie eine bevorzugte Verwendung der Erfindung (Anspruch 8).

Der wesentliche Vorteil der Erfindung besteht darin, daß die Signalwege und damit auch die Signallaufzeiten vor allem zwischen der eigentlichen Hochfrequenzschaltung auf der Oberseite des Substrats und der Dünnfilm-Mehrlagen-Logikschaltung auf der Ober- oder Unterseite des Substrats sehr kurz gehalten werden können, insbesondere dann, wenn an geeigneten Stellen diesbezügliche Durchkontaktierungen im Substrat bzw. in der Dünnfilm-Mehrlagen-Logikschaltung bzw. in der Hochfrequenzschaltung die Hochfrequenz- und die Logikschaltung direkt miteinander verbinden.

Schaltungen dieser Art können sehr kompakt aufgebaut werden (insbesondere dann, wenn auch die Hochfrequenzschaltung in Dünnfilm-Ein- oder Mehrlagentechnik aufgebaut wird) und eignen sich daher insbesondere für den Einsatz im Mikrowellenbereich z.B. in Sende/Empfangsmoduln für die einzelnen Antennenelemente eines Phased-Array-Radarsystems.

Im folgenden wird die Erfindung anhand der Figuren näher erläutert. Die Figuren zeigen bevorzugte Ausführungsbeispiele der erfindungsgemäßen Hochfrequenzschaltung in perspektivischer Darstellung von vorn, und zwar ein erstes Ausführungsbeispiel einmal mit sichtbarer Substrat-Oberseite (FIG. 1) und einmal mit sichtbarer Substrat-Unterseite (FIG. 2) sowie ein zweites Ausführungsbeispiel mit sichtbarer Substrat-Oberseite (FIG. 3).

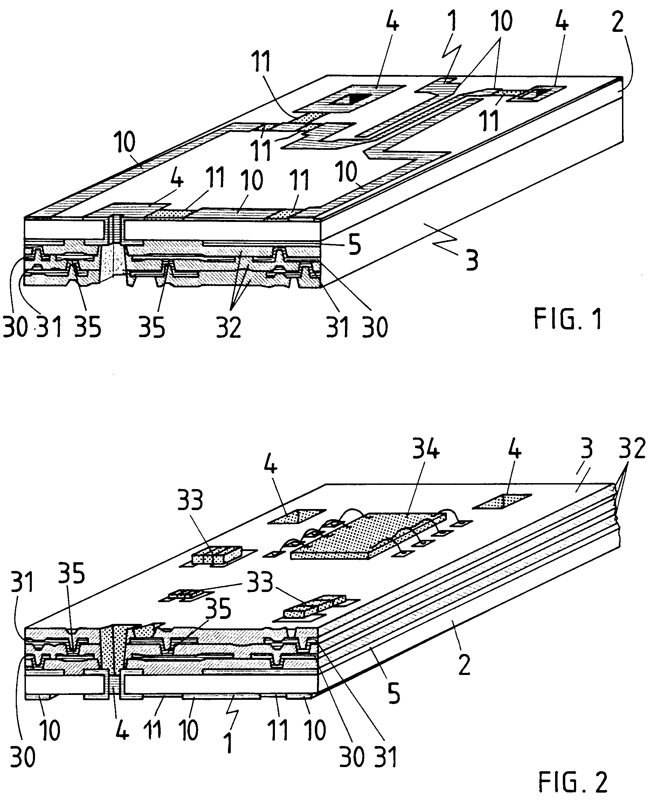

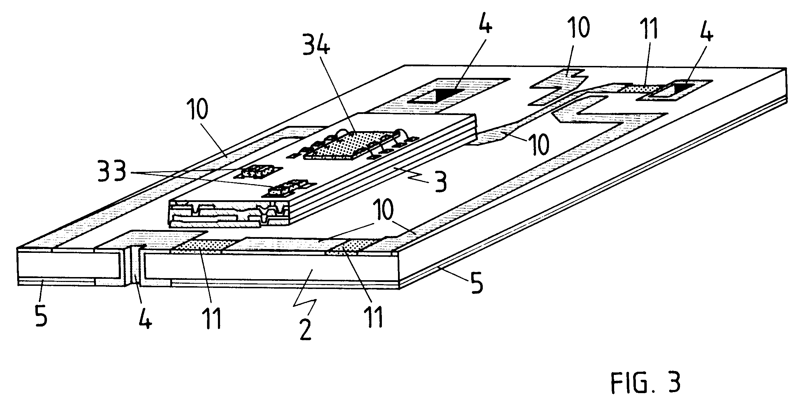

Die beiden dargestellten Schaltungen der Figuren 1 und 2 einerseits und FIG. 3 andererseits dienen als Sende/Empfangsmodul für die einzelnen Antennenelemente eines Phased-Array-Radarsystems, das im Mikrowellenbereich arbeitet.

In den Figuren wurden gleiche Bauteile mit den gleichen Bezugszeichen versehen.

Das Sende/Empfangsmodul des ersten Ausführungsbeispiels gemäß FIG. 1 und 2 besteht a) aus einer in Dünnfilmtechnik hergestellten planaren einlagigen Streifenleitungsstruktur 10 mit integrierten Dünnfilmwiderständen 11 (z.B. aus Nickelchrom (NiCr)) auf der Oberseite eines Substrats 2 (z.B. aus Aluminiumoxid (Al₂O₃)), die zusammen mit einer Grundmetallisierung 5 auf der Unterseite des Substrats 2 die eigentliche Hochfrequenzschaltung 1 bildet, und b) aus einer ebenfalls in Dünnschichttechnik hergestellten mehrlagigen Logikschaltung 3 auf der Unterseite des Substrats 2, die (beispielhaft) aus drei metallischen Leiterbahnschichten 5, 30 und 31 (Masse, x- und y-Signalebene) besteht (die Grundmetallisierung 5 ist gleichzeitig Teil der Hochfrequenzschaltung 1 und der Logikschaltung 3), die durch zwischenliegende Polymer-Isolationsschichten (Dielektrika) 32 z.B. aus Polyimid oder Benzocyclobuten voneinander getrennt sind und die nur über V-förmige Durchkontaktierungen 35 in den einzelnen Isolationsschichten 32 miteinander elektrisch leitend verbunden sind.

Über Durchkontaktierungen 4 im Substrat 2 ist ferner die Hochfrequenzschaltung 1 direkt mit der Logikschaltung 3 verbunden. Auf der obersten Isolationsschicht 32 der Logikschaltung sind ferner über metallische Anschlußflächen, die mit den darunter liegenden Leiterbahnschichten über Durchkontaktierungen 35 elektrisch leitend verbunden sind, weitere diskrete Bauelemente wie z.B. ein ASIC 34 oder Widerstände bzw. Kondensatoren 33 an die Logikschaltung 3 angeschlossen.

Mit dieser geschichteten Bauweise der einzelnen Schaltungsstrukturen 5, 30, 31 innerhalb der Logikschaltung 3 wie auch der Logikschaltung 3 und der Hochfrequenzschaltung 1 insgesamt mit elektrischen Verbindungen zwischen den einzelnen Schaltungsstrukturebenen 5, 30, 31 bzw. 1, 3 in Form von Durchkontaktierungen 35 bzw. 5 können die Signalwege und damit auch die Signallaufzeiten sehr kurz gehalten werden, was sich insbesondere zu höheren Frequenzen hin sehr positiv auf die Funktionsfähigkeit der Schaltung auswirkt.

Die Schaltung insgesamt ist sehr kompakt in ihrem Aufbau und kommt daher der insbesondere im Mikrowellenbereich häufig gestellten Forderung nach miniaturisierten Baugruppen sehr entgegen.

Das sende/Empfangsmodul des zweiten Ausführungsbeispiels gemäß FIG. 3 unterscheidet sich von dem Ausführungsbeispiel der FIG. 1 und 2 lediglich dadurch, daß die Dünnfilm-Mehrlagenlogikschaltung 3 zusammen mit den Hochfrequenz-Streifenleitungsstrukturen 10, 11 auf der Oberseite des Substrats 2 integriert ist. Wesentlicher Vorteil dieser "einseitigen" Integration der Hochfrequenz- und Logikschaltungsstrukturen sind noch kostengünstigere Fertigungsbedingungen, die im wesentlichen bedingt sind durch einen verminderten technischen Aufwand in der Aufbau- und Verbindungstechnik.

Es versteht sich, daß die Erfindung nicht nur auf diese Ausführungsbeispiele beschränkt ist, sondern vielmehr auf andere Beispiele sinngemäß anwendbar ist.

So ist z.B. denkbar, auch die Hochfrequenzschaltung als Dünnfilm-Mehrlagenschaltung auszuführen. Ferner können andere Substrat- und/oder Polymer-Dielektrikamaterialien eingesetzt werden (z.B. Aluminiumnitrid, Siliziumnitrid als Substrat).

## Patentansprüche

1. Hochfrequenzschaltung mit integrierter Logikschaltung, wobei die Hochfrequenzschaltung als planare Schaltung auf der Oberseite eines Substrats angeordnet ist mit einer Grundmetallisierung der Unterseite des Substrats, dadurch gekennzeichnet, daß die integrierte Logikschaltung (3) als Dünnfilm-Mehrlagenschaltung auf der Unterseite des Substrats (2) unter Einbeziehung der Grundmetallisierung (5) oder auf der Oberseite des Substrats (2) ausgebildet ist.

2. Hochfrequenzschaltung nach Anspruch 1, dadurch gekennzeichnet, daß die planare Hochfrequenzschaltung (1) auf der Oberseite des Substrats (2) über mindestens eine Durchkontaktierung (4) mit der Dünnfilm-Mehrlagenschaltung (3) auf der Unterseite des Substrats (2) verbunden ist.

3. Hochfrequenzschaltung nach einem der vorhergehenden Ansprüche, dadurch gekennzeichnet, daß die planare Hochfrequenzschaltung (1) ebenfalls in Dünnfilmtechnik hergestellt ist.

4. Hochfrequenzschaltung nach Anspruch 3, dadurch gekennzeichnet, daß die planare Dünnfilm-Hochfrequenzschaltung (1) mindestens eine Streifenleitung (10) und/oder mindestens einen in Dünnfilmtechnik integrierten Widerstand (11), vorzugsweise einen NiCr-Widerstand aufweist.

5. Hochfrequenzschaltung nach einem der vorhergehenden Ansprüche, dadurch gekennzeichnet, daß die Dünnfilm-Mehrlagenschaltung (3) auf der Unterseite des Substrats (2) einschließlich der Grundmetallisierung (5) mehrere jeweils durch ein Polymer-Dielektrikum (32) voneinander getrennte metallische Leiterbahnschichten (5, 30, 31) aufweist.

6. Hochfrequenzschaltung nach Anspruch 5, dadurch gekennzeichnet, daß als Polymer-Dielektrium (32) Polyimid oder Benzocyclobuten vorgesehen ist.

7. Hochfrequenzschaltung nach einem der vorhergehenden Ansprüche, dadurch gekennzeichnet, daß als Substrat (2) ein Keramiksubstrat insbesondere aus Aluminiumoxid (Al₂O₃) vorgesehen ist.

8. Hochfrequenzschaltung nach einem der vorhergehenden Ansprüche, gekennzeichnet durch die Verwendung in einem Sende/Empfangsmodul für einzelne Antennenelemente eines Phased-Array-Radarsystems.
